Europäisches Patentamt

European Patent Office

Office européen des brevets

(11) Publication number: **0 279 453 B1**

## EUROPEAN PATENT SPECIFICATION

(45) Date of publication of patent specification: **05.08.92**    (51) Int. Cl.⁵: **H01L 27/10**, G11C 7/00

(21) Application number: **88102448.3**

(22) Date of filing: **19.02.88**

(54) **Reference potential generating circuit for a semiconductor device.**

(30) Priority: **20.02.87 JP 35807/87**

(43) Date of publication of application:
**24.08.88 Bulletin  88/34**

(45) Publication of the grant of the patent:
**05.08.92 Bulletin  92/32**

(84) Designated Contracting States:
**DE FR GB**

(56) References cited:
**EP-A- 0 136 119**
**GB-A- 2 078 458**
**US-A- 3 938 108**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Ohtsuka, Nobuaki c/o Patent Division**
**Kabushiki Kaisha Toshiba 1-1 Shibaura**
**1-chome**
**Minato-ku Tokyo 105(JP)**
Inventor: **Tanaka, Sumio c/o Patent Division**
**Kabushiki Kaisha Toshiba 1-1 Shibaura**
**1-chome**
**Minato-ku Tokyo 105(JP)**

Inventor: **Miyamoto, Junichi c/o Patent Division**
**Kabushiki Kaisha Toshiba 1-1 Shibaura**
**1-chome**
**Minato-ku Tokyo 105(JP)**
Inventor: **Atsumi, Shigeru c/o Patent Division**
**Kabushiki Kaisha Toshiba 1-1 Shibaura**
**1-chome**
**Minato-ku Tokyo 105(JP)**
Inventor: **Imamiya, Keniti c/o Patent Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte Ar-**
**abellastrasse 4**
**W-8000 München 81(DE)**

## Description

This invention relates to a reference potential generating circuit for use in a semiconductor device, for generating a reference potential which is used for comparison with a potential read out from a memory cell.

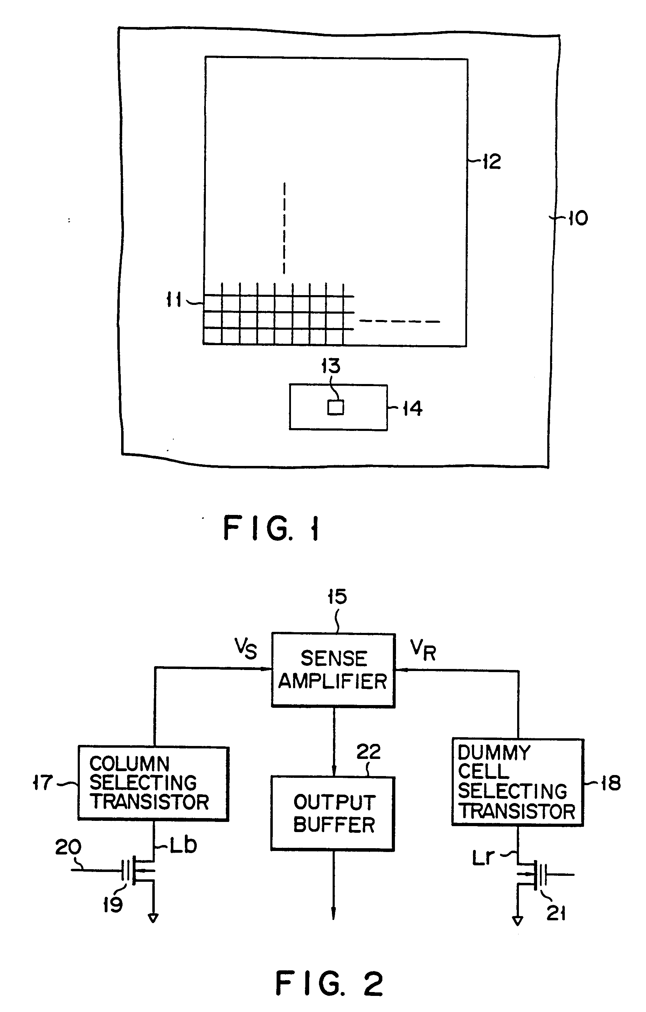

An EPROM (electrically programmable read only memory) device contains a sense amplifier which is used to compare a bit line potential, representing data stored in a selected memory cell, with a reference potential, in order to determine whether the logical state of the data stored in the memory cell is logical "1" or "0". The circuit for generating such a reference potential generally comprises a dummy cell having the same characteristic as a memory cell; in other words, a dummy cell whose cell pattern is the same as that of the memory cell is used in the reference potential generating circuit. Such a circuit is known from US-A-3 938 108. On the semiconductor chip, the dummy cell is located away from the memory cell array area made up of a plurality of memory cells, as is shown in Fig. 1. In this figure, reference numeral 10 designates a semiconductor chip, 11 a memory cell, 12 a memory cell array composed of memory cells 11 arranged in a matrix fashion, 13 a dummy cell for generating a reference potential, and 14 a reference potential generating circuit region with dummy cell 13. Since dummy cell 13 defines a reference potential used for determining the logical state of the data stored in a selected memory cell 11, the transistor characteristic of the dummy cell must be the same as that of a memory cell. It is for this reason that the cell pattern of dummy cell 13 must be identical to that of memory cell 11.

In a semiconductor memory device, memory cell size is one of the most important factors determining the size of the chip area. For this reason, the memory cell pattern is designed according to the strictest design standards. In recent semiconductor memory devices, the memory capacity has been increased, and the element size has been reduced. In such memory devices, the memory cells and the dummy cell are designed having the same cell pattern. Actually, however, the patterns of these memory cells and the dummy cell formed are different. For example, when the width of the interconnection layer is 1.2 $\mu$m, the memory cells formed have the design value in size. However, the separated dummy cell has a value in size different from the design value. More exactly, the size of the contact holes of the memory cells formed is 1.3 $\mu$m $\times$ 1.6 $\mu$m which is the design value, while the contact hole size of the dummy cell is different from the design value. Though it is unknown why such a phenomenon will occur, it is estimated that a stress caused in a resist film used in forming the contact holes of these memory cells might be larger than that caused in a resistive film used in forming the contact holes of a single dummy cell. This large stress might contract the geometry of the contact hole of the dummy cell. When the geometry of the contact hole of the dummy cell is contracted, it is impossible to correctly read out data. further, when the patterns of the polysilicon layers of the control gate and the floating gate of the dummy cell differ from those of the memory cells, the gate lengths and the gate-coupling ratios are different between the memory cells on the one hand, and the dummy cell, on the other hand. Consequently, the transistor characteristics of these cells become different, resulting in inexact reading of data.

As described above, in the reference potential generating circuit for the semiconductor memory device, even if the memory cells and the dummy cell have the same design value for the pattern geometries, the pattern geometries of the memory and dummy cells manufactured are different from each other. This leads to the semiconductor memory devices manufactured being of poor reliability.

Accordingly, an object of this invention is to provide a semiconductor memory device which is free from the reliability problem arising from the different pattern geometry of the single dummy cell and the arrayed memory cells.

To achieve the above object, a plurality of dummy cells forming a dummy cell array is formed in the semiconductor chip. A dummy cell surrounded by other dummy cells in the array is used as a dummy cell for generating a reference potential. The contact of a Vss line for connecting the source of the dummy cell to the ground is located at the center portion of the dummy cell array.

With such a layout, the cell pattern of the dummy cell may be the same as that of the memory cells. Accordingly, the transistor characteristics of these cells may also be substantially identical to each other. Thus, the problem due to the difference in the cell pattern geometry can be solved.

According to the present invention, there is provided a reference potential generating circuit for a semiconductor memory device, comprising a first memory cell for data storage, bias means for generating a potential as a reference, to determine if a logical state of the data read out from said first memory cell is logical "1" or "0", by applying a predetermined bias voltage to the drain of said first dummy cell, wherein said first dummy cell is located in a dummy cell array including a plurality of dummy cells, which is laid around said first dummy cell, the contact holes of the drain and source of said first dummy cell are surrounded by the contact holes of said plurality of dummy cells in said dummy cell array.

This invention can be more fully understood from the following detailed description when taken in conjunction with the accompanying drawings, in which:

Fig. 1 is a block diagram showing a conventional semiconductor memory device including a reference potential generating circuit;

Fig. 2 shows a layout of a memory cell array for data storage and a dummy cell in a semiconductor memory device;

Fig. 3 shows a dummy cell array in a reference potential generating circuit for a semiconductor memory device according to an embodiment of this invention;

Fig. 4 shows a memory cell array in a reference potential generating circuit for the semiconductor memory device according to the Fig. 4 embodiment; and

Fig. 5 shows a dummy cell array in a reference potential generating circuit for a semiconductor memory device according to another embodiment of this invention.

Some specific embodiment of this invention will be described by referring to the accompanying drawings.

Fig. 2 shows a block diagram of a peripheral circuit including a reference potential generating circuit for a semiconductor memory device. In the figure, Lr denotes a reference potential line, Lb a bit line, 15 a differential amplifier connected between reference potential line Lr and bit line Lb, 17 a column selecting transistor connected to one input terminal of sense amplifier 15, 18 a dummy cell selecting transistor connected to the other input terminal of sense amplifier, 19 a memory cell for data storage connected between column selecting transistor 17 and ground potential, 20 a word line connected to the gate of the memory cell, 21 a dummy cell connected between dummy cell selecting transistor 18 and ground potential, 22 an output buffer connected to sense amplifier 15, $V_S$ potential of the data read out from memory cell 19, and $V_R$ a reference potential.

When word line 20 is enabled by a row decode signal and column selecting transistor 17 is turned on by a column signal, potential $V_S$ which corresponds to data stored in memory cell 19 arrears on bit line Lb. When the gate of dummy cell transistor 21 is enabled by a control signal and dummy cell selecting transistor 17 is turned on by a control signal, reference potential $V_R$ arrears on reference potential line Lb. Sense amplifier 15 comprises a differential amplifier for comparing the potential $V_R$ read out from memory cell 19 with reference potential $V_R$, in order to determine whether the logical state of the data read out of memory cell 19 is logical "1" or "0". The result of comparison from sense amplifier 15 is output via output buffer 22.

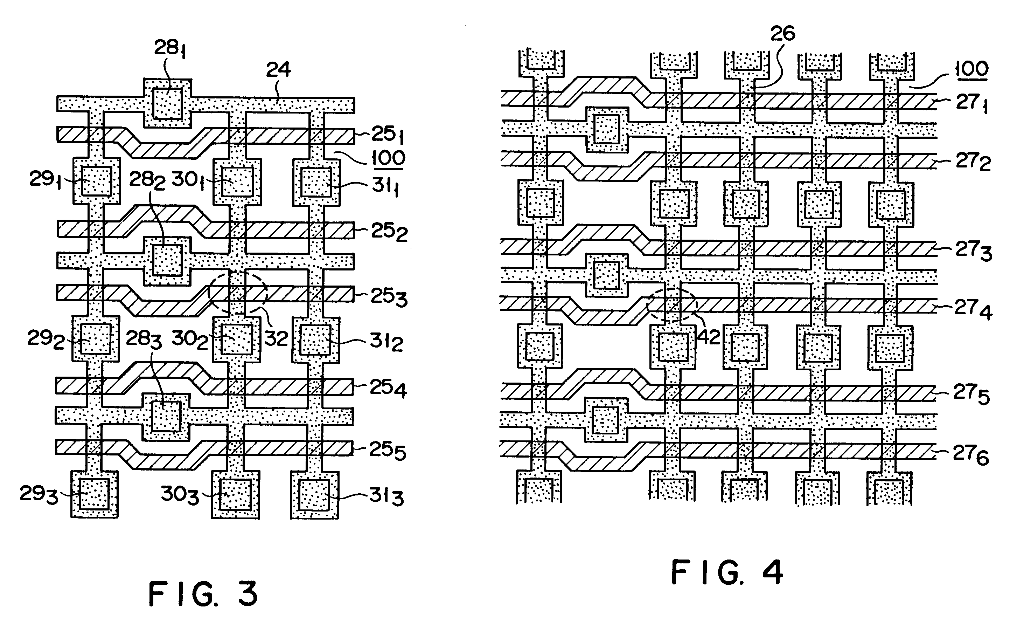

Fig. 3 shows a dummy cell array comprising a plurality of dummy cells including semiconductor region 32 forming dummy cell 21 shown in Fig. 2. Fig. 4 shows a memory cell array comprising a plurality of memory cells including semiconductor region 42 forming memory cells 19 shown in Fig. 2. In Fig. 3, reference numeral 24 indicates an impurity diffusion region formed in semiconductor chip 100, which extends in row and column directions to form a mesh. $25_1$ to $25_5$ denote word lines extending in the row direction. Transistors constituting dummy cells are formed at the cross points of impurity diffusion region 24 and word lines $25_1$ to $25_5$. The array pattern of the cell transistors is the same as that of cell transistors as memory cells shown in Fig. 4. In the memory array shown in Fig. 4, transistors constituting memory cells are formed at the cross points of impurity diffusion region 26 and word lines $27_1$ to $27_6$. In Fig. 4, numeral 26 designates an impurity diffusion region formed in semiconductor chip 100, and it is configured like a mesh extending in the row and column directions. Word lines $27_1$ to $27_6$ are arrayed in the row direction. Transistors constituting memory cells are formed at the cross points of impurity diffusion region 26 and these word lines $27_1$ to $27_6$. The array pattern of the memory cell transistors is the same as that of the dummy cell shown in Fig. 3. In Figs. 3 and 4, aluminum wirings, such as a Vss line and bits lines, extending in the vertical direction or the column direction, are omitted for simplicity of illustration. In Fig. 3, diffusion region 24 in the source region of each transistor is connection to Vss line, via contact holes $28_1$ to $28_3$, and diffusion region 24 in the drain region is connected to the bit line via contact holes $29_1$ to $29_3$, $30_1$ to $30_3$ or $31_3$. The transistor in the region enclosed by a broken line is used as dummy cell 21 for generating a reference potential. To ensure a normal operation of this transistor, it is necessary that contact holes $28_2$ and $30_2$ formed have the design values. The reason for this is that contact hole $28_2$ is used to connect the source of the cell transistor to ground potential, and contact hole $30_2$ is used to connect the drain of cell transistor to the bit line. When considering contact holes $28_2$ and $30_2$ arranged in the dummy cell array, these contact holes are located at the center portion of the array, and is surrounded by contact holes $28_1$, $28_3$, $29_1$ to $29_3$, $30_1$, $30_3$, and $31_1$ to $31_3$. Therefore, the contact holes of the dummy cells in the dummy cell array are formed under the same condition as that for forming the contact holes of the memory cells in the memory cell array shown in Fig. 4. The pattern of the contact holes of the dummy cells is substantially the same as that of the memory cells.

Thus, the problem of the pattern deformation of the dummy cell, which is caused when a single dummy cell is formed, is overcome. The same thing is true for the patterning of the polysilicon layers of the control gate and the floating gate. The polysilicon layer of word line $25_3$ used for dummy cell gate, is sandwiched by other word lines $25_1$, $25_2$, $25_4$ and $25_5$, so that it is patterned under the same condition as that for the patterning of the polysilicon layers of word lines $27_1$ to $27_6$ in the memory cell array. As a result, the gate length of the dummy cell transistor is equal to that of the memory cell transistor, and a coupling ratio of the gates of the dummy cell transistor is equal to that of the memory cell transistor. Thus, these cell transistors may have the same transistor characteristics.

As described above, in the present invention, the patterning for forming the dummy cell for the reference potential generating circuit is performed under the same condition as that for the patterning of the memory cells, by providing a dummy cell array including a plurality of dummy cells around the key dummy cell for generating the reference potential. This feature of this invention successfully solved the problem of cell pattern deformation caused when the arrayed memory cells and the single dummy cell are patterned. In the semiconductor memory device microfabricated according to this invention, the memory cells and the dummy cell have the same transistor characteristics, improving the reliability of the semiconductor memory device.

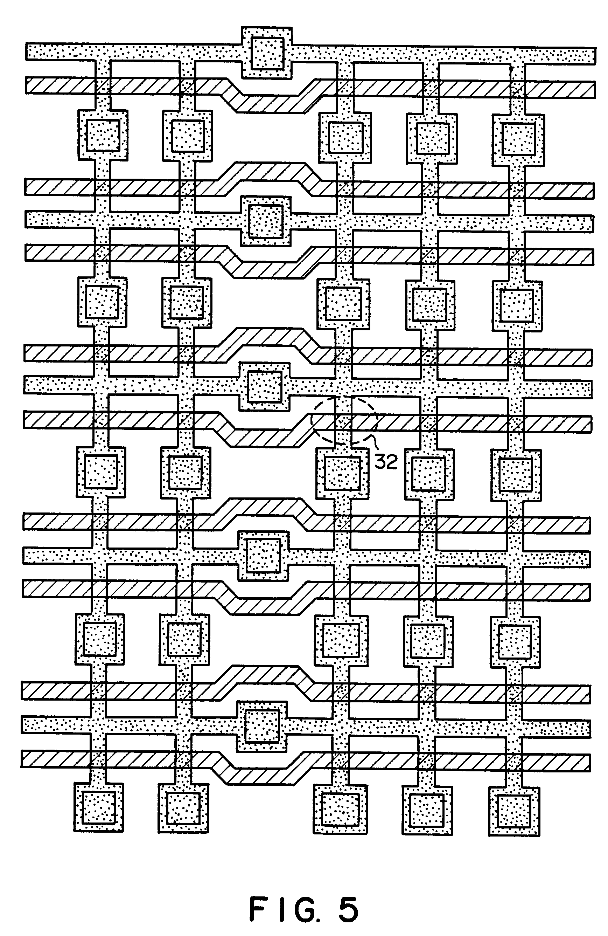

In the above-mentioned embodiment, the contact holes of the dummy cells constituting the dummy cell array are laid singly around the contact holes of the dummy cell for generating a reference potential. Alternatively, as shown in Fig. 5, the number of dummy cells is increased, and these may be laid doubly, for example, around the key dummy cell. If so, the pattern of the key dummy cell can be further close to that of the memory cells. In Fig. 5, for simplicity of illustration, only the region forming dummy cell 21 in Fig. 2 is designated by reference numeral 32, and no reference numerals are applied to the remaining regions.

As described above, a reference potential generating circuit for a semiconductor memory device according to this invention is free from the pattern deformation problem of the dummy cell, and is reliably operable.

## Claims

1. A reference potential generating circuit for a semiconductor memory device, comprising a first memory cell (19) for storing data, a first dummy cell (21) for storing reference data, and a sense amplifier (15) for comparing the data stored in said first memory cell with the reference data stored in said first dummy cell, to determine if a logical state of the data read out from said first memory cell is logical "1" or "0", characterized in that said first dummy cell is located in a dummy cell array including a plurality of second dummy cells, which is laid around said first dummy cell, and the contact holes ($30_2$, $28_2$) of the drain and source of said firs dummy cell are surrounded by the contact holes ($28_1$, $28_3$, $29_1$ - $29_3$, $30_1$, $30_3$, $31_1$ - $31_3$) of said plurality of second dummy cells in said dummy cell array.

2. The reference potential generating circuit according to claim 1, characterized in that the contact holes of the drain and source of said first dummy cell are surrounded singly by the contact holes of said plurality of second dummy cells of said dummy cell array.

3. The reference potential generating circuit according to claim 1, characterized in that the contact holes of the drain and source of said first dummy cell are surrounded in a multiple way by the contact holes of said plurality of second dummy cells of said dummy cell array.

## Revendications

1. Circuit générateur d'un potentiel de référence destiné à un dispositif de mémoire à semi-conducteur, comprenant une première cellule de mémoire (19) destinée à conserver des données, une première cellule factice (21) destinée à conserver des données de référence, et un amplificateur de détection (15) destiné à comparer les données conservées de la première cellule de mémoire aux données de référence conservées dans la première cellule factice, afin qu'il détermine si un état logique des données lues dans la première cellule de mémoire est un état logique "1" ou "0", caractérisé en ce que la première cellule factice est placée dans un matrice de cellules factices comprenant plusieurs secondes cellules factices, placées autour de la première cellule factice, et les trous de contact ($30_2$, $28_2$) du drain et de la source de la première cellule factice sont entourés par les trous de contact ($28_1$, $28_3$, $29_1$-$29_3$, $30_1$, $30_3$, $31_1$-$31_3$) des secondes cellules factices de la matrice de cellules factices.

2. Circuit générateur d'un potentiel de référence selon la revendication 1, caractérisé en ce que les trous de contact du drain et de la source de la première cellule factice sont entourés uniquement par les trous de contact de plusieurs secondes cellules factices de la matrice de cellules factices.

3. Circuit générateur d'un potentiel de référence selon la revendication 1, caractérisé en ce que les trous de contact du drain et de la source de la première cellule factice sont entourés de manière multiple par les trous de contact de plusieurs secondes cellules factices de la matrice de cellules factices.

**Patentansprüche**

1. Bezugspotentialerzeugungsschaltung für eine Halbleiterspeichereinrichtung, mit einer ersten Speicherzelle (19) zum Speichern von Daten, einer ersten Blindzelle (21) zum Speichern von Bezugsdaten, und einem Leseverstärker (15) zum Vergleichen der in der ersten Speicherzelle gespeicherten Daten mit den in der ersten Blindzelle gespeicherten Bezugsdaten, um festzustellen, ob der logische Zustand der aus der ersten Speicherzelle ausgelesenen Daten die logische "1" oder "0" ist,
dadurch **gekennzeichnet,** daß die erste Blindzelle in einem Blindzellenfeld plaziert ist, das eine Vielzahl von zweiten Blindzellen umfaßt, die um die erste Blindzelle herum angeordnet sind, und daß die Kontaktlöcher ($30_2$, $28_2$) der Senke (Drain) und der Quelle (Source) der ersten Blindzelle von den Kontaktlöchern ($28_1$, $28_3$, $29_1$-$29_3$, $30_1$, $30_3$, $31_1$-$31_3$) der Vielzahl der zweiten Blindzellen in dem genannten Blindzellenfeld umgeben sind.

2. Bezugspotentialerzeugungsschaltung nach Anspruch 1, dadurch **gekennzeichnet,** daß die Kontaktlöcher der Drain und der Source der ersten Blindzelle einzeln durch die Kontaktlöcher der Vielzahl der zweiten Blindzellen des genannten Blindzellenfeldes umgeben sind.

3. Bezugspotentialerzeugungsschaltung nach Anspruch 1, dadurch **gekennzeichnet,** daß die Kontaktlöcher des Drain und der Source der ersten Blindzelle mehrfach von den Kontaktlöchern der Vielzahl der zweiten Blindzellen des genannten Blindzellenfeld umgeben sind.

F I G. 1

F I G. 2

EP 0 279 453 B1

FIG. 3

FIG. 4

FIG. 5